# EUROPEAN PATENT APPLICATION

(11) **EP 3 470 211 A1**
(43) Date of publication of application: **17.04.2019**
(21) Application number: 17196455.4
(22) Date of filing: 13.10.2017
(51) Int. Cl.: B29C 64/386, B33Y 50/00

(54) **METHOD FOR OPERATING AN APPARATUS FOR ADDITIVELY MANUFACTURING OF THREE-DIMENSIONAL OBJECTS**

(71) Applicant: CL Schutzrechtsverwaltungs GmbH, 96215 Lichtenfels (DE)
(72) Inventor: Pilzweger, Florian, 96215 Lichtenfels (DE); Lippert, Markus, 96215 Lichtenfels (DE)
(74) Representative: Hafner & Kohl

(57) **Abstract**

Method for operating an apparatus (1) for additively manufacturing of three-dimensional objects (2) by means of successive layerwise selective irradiation and consolidation of layers of a build material (3) which can be consolidated by means of an energy beam (4), wherein at least one process parameter of the apparatus (1), in particular a key performance parameter, is automatically repeatedly determined on basis of a machine-implemented determination routine, wherein the at least one determined process parameter is stored and automatically evaluated with respect to at least one evaluation criterion.

## Description

The invention relates to a method for operating an apparatus for additively manufacturing of three-dimensional objects by means of successive layerwise selective irradiation and consolidation of layers of a build material which can be consolidated by means of an energy beam.

Such methods are generally known in prior art and are used to operate additive manufacturing apparatuses in that at least one energy beam, e.g. a laser beam, is guided over a build plane, i.e. a surface of build material arranged in a process chamber of the apparatus, to irradiate and thereby consolidate the build material arranged in the build plane. By successively irradiating and consolidating multiple layers of build material, the three-dimensional object can be built.

Further, it is known from prior art that process parameters, for example a focal position of the energy beam or the energy depleted in the build material via the energy beam has to be calibrated, for example in predefined time intervals. To calibrate the additive manufacturing apparatuses, typically a plant operator measures the respective process parameter, such as the focal position of the energy beam, and verifies whether the process parameter is within a defined interval or matches a defined value. Dependent on the result of the verification process performed by the operator, the operator needs to adjust the process parameter or other parameters of the apparatus affecting the process parameter, respectively, in that a proper calibration status of the additive manufacturing apparatus is met.

Thus, the method, as described with respect to the known prior art, requires an operator of the apparatus to perform the calibration routine. After calibrating the apparatus, in particular after adjusting the at least one process parameter, the original value of the process parameter is overwritten by performing the calibration routine and therefore, the original value is lost. Therefore, an evaluation of the calibration status over time, in particular relating to repeatedly occurring influences on the manufacturing process, is not possible.

It is an object to provide an improved method for operating an apparatus for additively manufacturing of three-dimensional objects, in particular a method that allows for an automated evaluation of the behavior of at least one process parameter and that allows for an automated calibration of at least one process parameter.

The object is inventively achieved by an apparatus according to claim 1. Advantageous embodiments of the invention are subject to the dependent claims.

The method described herein is a method for operating an apparatus for additively manufacturing three-dimensional objects, e.g. technical components, by means of successive layerwise selective irradiation and consolidation of layers of a powdered build material ("build material") which can be consolidated by means of an energy beam. A respective build material can be a metal, ceramic or polymer powder. A respective energy beam can be a laser beam or an electronic beam. A respective apparatus can be a selective laser sintering apparatus, a selective laser melting apparatus or a selective electron beam melting apparatus, for instance.

The respective apparatus may comprise a number of functional units which are used during its operation. Exemplary functional units are a process chamber, an irradiation device which is adapted to selectively irradiate a build material layer disposed in the process chamber with at least one energy beam, and a stream generating device which is adapted to generate a gaseous fluid stream at least partly streaming through the process chamber with given streaming properties, e.g. a given streaming profile, streaming velocity, etc. The gaseous fluid stream is capable of being charged with non-consolidated particulate build material, particularly smoke or smoke residues generated during operation of the apparatus, while streaming through the process chamber. The gaseous fluid stream is typically inert, i.e. typically a stream of an inert gas, e.g. argon, nitrogen, carbon dioxide, etc.

The invention is based on the idea that at least one process parameter of the apparatus, in particular a key performance parameter, is automatically repeatedly determined on basis of a machine-implemented determination routine, wherein the at least one determined process parameter is stored and automatically evaluated with respect to at least one evaluation criterion. The process parameter may particularly be a "key performance parameter", i.e. a parameter from which the current calibration status of the additive manufacturing apparatus can be derived. Such key performance parameters may directly affect the manufacturing process performed on the apparatus. Examples of respective key performance parameters will be given below.

Thus, the method for operating an apparatus for additively manufacturing of three-dimensional objects suggests that at least one process parameter of the apparatus is automatically determined. The determination of the at least one process parameter is therefore, performed automatically and repeatedly on basis of a machine-implemented determination routine. Hence, dependent on the machine-implemented determination routine, the apparatus automatically performs a calibration procedure, for example with respect to at least one process parameter, such as a focal position of the energy beam. Thus, it is not necessary that an operator of the additive manufacturing apparatus performs or initiates the determination routine or the calibration routine, respectively. Instead, the apparatus itself automatically performs the determination routine to determine the at least one process parameter.

Further, the method described throughout this application suggests that the at least one determined process parameter is stored and automatically evaluated with respect to at least one evaluation criterion. The information generated by determining the at least one process parameter is automatically stored. Hence, the original process parameter that is determined is not merely overwritten and therefore, lost by calibrating the apparatus, but the determined process parameter is automatically stored before the process parameter is adjusted. This allows for an evaluation of the status of the additive manufacturing apparatus before the calibration routine was performed. In particular, the evaluation of the at least one determined process parameter is performed with respect to at least one evaluation criterion, as will be described subsequently.

The at least one evaluation criterion may relate to the long-term behavior of the at least one process parameter and/or to a calibration status of the apparatus. Thus, from the determination of the at least one process parameter the calibration status can be derived, wherein the additive manufacturing apparatus is controlled in that the calibration status is automatically determined and stored. In particular, the determined process parameter is compared to a defined value of the corresponding process parameter, for example a focal position of the energy beam or various other key performance parameters, as will be described below. Dependent on the calibration status that is evaluated from the at least one determined process parameter, it can be decided, e.g. via a control unit, whether it is necessary to calibrate the additive manufacturing apparatus with respect to the corresponding determined process parameter or whether the determined process parameter is within a defined interval, for example within a tolerance interval.

Hence, an operator of the apparatus is not required to initiate and perform a calibration routine, for example by manually determining a process parameter, such as measuring a beam power and comparing the determined process parameter with a predefined value and subsequently adjusting the determined process parameter, if necessary. Instead, the additive manufacturing apparatus the method according to the described embodiment is performed on is adapted to automatically and repeatedly determine the process parameter and evaluate the calibration status based on the determination result. Dependent on the calibration status the respective process parameter may be adjusted accordingly.

The automated storing of the at least one determined process parameter additionally allows for an evaluation of a long-term behavior of the at least one process parameter. In other words, it can be evaluated if and how the at least one process parameter changes over time, in particular over long-term. The evaluation of the long-term behavior of the at least one process parameter allows for a determination of the effect of ambient influences, such as temperature and/or humidity changes over a defined period of time, for example a month or a year. Thus, influences affecting the manufacturing apparatus can be taken into account to improve the calibration routine. For example, by compensating repeatedly occurring ambient influences, the calibration routine can be adapted accordingly.

Another aspect of the automated evaluation of the calibration status or the long-term behavior of the at least one process parameter, respectively, is that influences on the manufacturing process can be identified and, for example, may be adapted or eliminated. For example, changing ambient parameters, such as climate changes over different times of the year, in particular a temperature and humidity rise in summer, can affect the ambient conditions in the process chamber and therefore, affect the manufacturing process. By automatically and repeatedly determining the relevant process parameters that are stored and automatically evaluated, it is possible to identify the effects of those influences, such as the temperature and/or a humidity rise, on the manufacturing process. Thus, it is possible to adjust the calibration routine in that the respective change of the ambient conditions can be taken into account and therefore, the additive manufacturing apparatus can be adjusted accordingly to compensate the effects on the manufacturing process, following this example, by adjusting the temperature and/or the humidity in the process chamber or around the process chamber accordingly.

The automated and repeated determination may be performed dependent on at least one initiation parameter. Thus, the at least one initiation parameter defines when the machine-implemented determination routine is performed. The at least one initiation parameter may be stored in a storage unit of the additive manufacturing apparatus, for example the storage unit may be assigned to a control unit. Further, multiple initiation parameters may be defined, wherein the determination routine is performed, if at least one of the multiple initiation parameters is met. Exemplary initiation parameters or parameters the at least one initiation parameter may comprise will be described below.

Alternatively or additionally, it is possible that at least one process parameter may be adjusted dependent on the at least one determined process parameter. Hence, the respective process parameter may be adjusted dependent on the current determined value of the process parameter, for example, if the determined process parameter is not within a predefined interval or a predefined value is not met, an adjustment may be necessary. Of course, it is also possible to indirectly adjust the process parameter, if the determined process parameter depends on another process parameter, for instance. By adjusting the other process parameter affecting the determined process parameter an indirect adjustment of the determined process parameter depending on the other process parameter is possible.

The at least one initiation parameter may be or comprise at least one of the following parameters:
- a time parameter, in particular relating to a time interval between two automated determinations of the at least one process parameter, preferably daily or weekly or monthly
- an incident parameter, in particular dependent on at least one process step, preferably at the beginning and/or the end of a manufacturing process and/or at a tool change
- a current and/or a future work load of the apparatus
- an operator input

Therefore, the initiation parameter may comprise a time parameter, wherein the automated determination of the process parameter is repeated dependent on the time parameter set, for example after a predefined time has passed since the last automated determination. The time parameter may particularly relate to a time interval between two automated determinations of the at least one process parameter. In other words, the time parameter defines the time interval between two automated determinations. The time parameter may be set in that the automated determination is performed daily or weekly or monthly.

Further, the at least one initiation parameter may be or comprise an incident parameter. Thus, the automated determination is performed dependent on an incident or if a predefined circumstance occurs. In particular, the incident parameter may depend on at least one process step. Hence, if the additive manufacturing apparatus performs, e.g. before the beginning or after the end of a predefined process step, the automated determination routine may be performed. Preferably, a tool change may be used to initiate the determination routine. This embodiment allows for an automated determination of the at least one relevant process parameter and/or an automated calibration of the additive manufacturing apparatus, if certain process steps are finished or before certain process steps are begun. In particular, after a tool of the additive manufacturing apparatus is changed, relevant process parameters are automatically determined and the additive manufacturing apparatus is calibrated, as described above.

The incident parameter may further comprise a current and/or a future work load of the apparatus. This allows for performing the determination routine and/or the calibration routine in periods with low work load. Hence, the current and/or the future work load of the apparatus can be determined to decide whether the current workload is too high to perform the determination routine. The current and/or the future work load can therefore be evaluated in that a window for performing the determination routine is searched in which the apparatus is not working to capacity. Alternatively, a priority of at least one process step can be determined, wherein a decision whether or not to perform the determination routine may be based on the determined priority. According to this embodiment, it can be avoided to perform the determination routine in times of high workload, wherein, instead, the determination routine can be performed whenever the apparatus is not working to capacity, for example whenever the apparatus is idle. In particular, the determination routine may be performed overnight or on weekends or according to a predefined schedule. It is, of course, also possible that a plant operator defines the initiation parameter, e.g. by defining the date for performing the determination routine the at least one process parameter is determined and evaluated, as described above.

The at least one process parameter may be or at least comprise one of the following parameters:
- an irradiation parameter, in particular a beam parameter, preferably a spot size and/or a scanning speed and/or a beam power and/or a wavelength and/or a focal length and/or a positioning accuracy
- a moving speed of at least one component of the apparatus, in particular a carrying device
- a positioning accuracy, in particular of the carrying device

As described above, a process parameter, in particular a key performance parameter, of the additive manufacturing apparatus is a parameter that (directly) affects the manufacturing process of the at least one three-dimensional object manufactured on the additive manufacturing apparatus. Using the determination routine and the calibration routine and can be assured that the relevant process parameters remain in predefined intervals or accept predefined values.

The process parameter may, for example, be an irradiation parameter, in particular a beam parameter, preferably a spot size and/or a scanning speed and/or a beam power and/or a wavelength and/or a focal length and/or a positioning accuracy of the energy beam. Thus, the irradiation parameter generally refers to the irradiation of build material, particularly to parameters of an irradiation device that are controllable, for example by a control unit. A respective irradiation device of the apparatus comprises respective means for generating the energy beam and guiding the energy beam onto the build plane. By controlling at least one of the irradiation parameters the manufacturing process can directly be affected.

The process parameter may also comprise or relate to a moving speed of at least one component of the apparatus, in particular a carrying device. The carrying device is used to carry the non-consolidated build material and the object that has already been built during the manufacturing process. In other words, the carrying device carries the powder bed the three-dimensional object is manufactured in. Further, a positioning accuracy of the energy beam or the carrying device can be automatically determined. By determining the moving speed of the component of the apparatus or the positioning accuracy, conclusions on the manufacturing process can be made. To ensure that a predefined quality of the object is met during the manufacturing process, the relevant parameters, in particular the key performance parameters, have to be met or accept values within predefined intervals.

The evaluation of the calibration status may be performed dependent on the at least one determined process parameter and at least one reference parameter. Thus, to evaluate the calibration status of the apparatus the at least one determined process parameter and at least one reference parameter may be compared, wherein a difference between the determined process parameter and a (predefined) reference parameter can be determined. If the determined difference between the determined process parameter and the reference parameter exceeds a predefined (threshold) value, a calibration of the apparatus may be necessary. Thus, the calibration status of the apparatus may be referred to as "not calibrated". Also, if the determined difference between the determined process parameter and that reference parameter is below a predefined (threshold) value, in particular if the determined process parameter matches the reference parameter, a calibration of the apparatus may not be necessary, in that the determined process parameter does not have to be adjusted. The corresponding calibration status of the apparatus may be referred to as "calibrated".

The evaluated calibration status may be stored and evaluated over a defined period of time, in particular over a month and/or over a year, wherein a change of the at least one process parameter and/or the calibration status over the defined period can be evaluated. According to this embodiment, it is possible to monitor a change of the calibration status and/or a change of at least one process parameter over a defined time interval. Therefore, the calibration status is stored, for example in a storage unit assigned to the additive manufacturing apparatus. Thus, the behavior of the additive manufacturing apparatus in terms of the calibration status, for example with respect to a defined process parameter, can be evaluated over a defined period of time, in particular over a month and/or over a year.

The change of the calibration status over time, in particular how much the at least one process parameter deviates from the corresponding reference parameter, indicates how stable the additive manufacturing process or the additive manufacturing apparatus, respectively, is and can be used to define the time interval or the date on which the determination routine has to be repeated.

Further, at least two calibration statuses that are evaluated in corresponding parts of the time period, in particular evaluated in the same week or month of the period of time and/or at least two process parameters that are determined in corresponding parts of the period of time, in particular determined in the same week or month of the period of time are compared, wherein a change information is generated. Therefore, the two calibration statuses may be evaluated and/or the two process parameters may be determined at the beginning and at the end of the corresponding period of time, for instance. Of course, it is also possible to define other parts of the period of time the at least two calibration statuses are evaluated or process parameters are determined in.

By comparing at least two calibration statuses in the same period of time or at least two process parameters determined in the same period of time, a change information can be generated. The change information may relate to the behavior of the additive manufacturing apparatus or at least one process parameter of the same over the defined period of time. Hence, the change information contains or it can be derived from the change information, whether the apparatus runs stable or whether a change in the calibration status and/or the at least one process parameter occurs that makes an adjustment of the process parameter, in particular a calibration of the apparatus, necessary.

The method can further be improved in that at least one preset can be provided that defines the at least one process parameter to be determined and/or the at least one process parameter to be adjusted and/or the at least one initiation parameter. According to this embodiment, the preset defines several parameters of the determination routine and/or the calibration routine, in that via the preset defines which process parameters are determined.

Further, the preset may define whether or not a determined process parameter has to be adjusted, for example by defining a tolerance value or by defining the difference between the determined process parameter and the corresponding reference parameter that has to be exceeded that an adjustment of the process parameter or a calibration of the apparatus, respectively, is deemed necessary. Additionally or alternatively, the preset may define or contain information relating to the at least one initiation parameter. Thus, the initiation parameter can be set via the preset. Preferably, multiple presets are provided, wherein for different manufacturing apparatuses or different manufacturing processes, in particular for manufacturing different objects, different presets can be chosen.

The preset may further define at least one tolerance limit for the at least one process parameter, in particular different tolerance limits for different process parameters. Thus, the difference between the determined process parameter and the corresponding reference parameter must accept a value below the defined tolerance limit. If the difference exceeds the tolerance limit for the at least one process parameter, the calibration routine has to be performed. Preferably, the preset contains information defined by a standard or a norm, wherein, in particular tolerance limits, can be implemented in the determination routine and the calibration routine based on certain values, for example tolerance limits, that are defined within the standard.

According to another embodiment of the method, multiple presets are provided, wherein a preset can be selected dependent on the manufacturing process, in particular dependent on the object to be manufactured. Thus, for the manufacturing of different objects different criteria may apply, for example different tolerance limits for different process parameters. Thus, the process can be selected dependent on the object that has to be manufactured on the additive manufacturing apparatus to ensure that the defined process parameters are adjusted accordingly, i.e. that a defined calibration status of the apparatus is met to ensure that certain quality requirements of the built objects are complied with.

The method preferably comprises the following steps:
- initiating a calibration routine based on the initiation parameter
- automatically setting the apparatus in a calibration mode
- determining at least one process parameter
- storing the at least one determined process parameter
- evaluating a calibration status
- adjusting at least one process parameter dependent on the calibration status

Thus, the determination routine and/or the calibration routine are initiated based on the initiation parameter. As described before, various initiation parameters can be defined and monitored. For example, the initiation parameter may comprise a defined time interval or be triggered based on an incident.

After the initiation parameter is triggered, the apparatus for additively manufacturing three-dimensional objects is automatically set in a determination mode. In this determination mode at first, at least one process parameter, in particular a key performance parameter, is automatically determined. The determined process parameter is stored, for example in a storage unit of the additive manufacturing apparatus.

Based on the stored determined process parameter a calibration status of the additive manufacturing apparatus (or at least a component of the additive manufacturing apparatus, such as an irradiation device) is evaluated. If necessary, at least one process parameter is adjusted dependent on the calibration status. Thus, it can be assured that the respective process parameter accepts a predefined value or a value in a predefined interval.

Besides, the invention relates to an apparatus for additively manufacturing of three-dimensional objects by means of successive layerwise selective irradiation and consolidation of layers of a build material which can be consolidated by means of an energy beam, wherein a control unit is provided that is adapted to automatically determine at least one process parameter of the apparatus, in particular a key performance parameter, dependent on at least one initiation parameter, wherein the control unit is adapted to store the at least one determined process parameter in a storage unit and/or the control unit is adapted to adjust at least one process parameter dependent on the at least one determined process parameter.

Of course, all details, advantages and features described with respect to the inventive method are fully transferable to the inventive apparatus. In particular, the inventive method can be performed on the inventive apparatus.

Exemplary embodiments of the invention are described with reference to the Fig. The Fig. is a schematic diagram showing an inventive additive manufacturing apparatus.

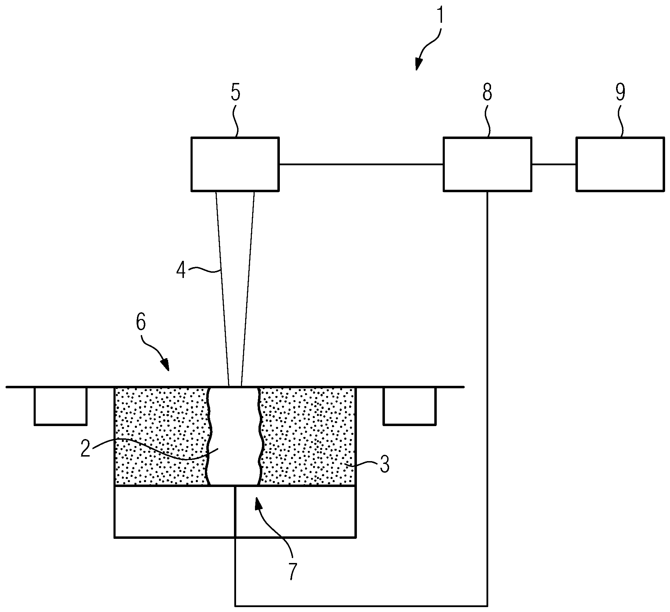

The sole Fig. shows an apparatus 1 for additively manufacturing of three-dimensional objects 2 by means of successive layerwise selective irradiation and consolidation of layers of a build material 3 which can be consolidated by means of an energy beam 4. The energy beam 4 is generated by an irradiation device 5 that is adapted to generate and guide the energy beam 4 onto a build plane 6. In other words, the energy beam 4 can be guided over the build plane 6, in that the build material 3 arranged in the build plane 6 can be directly irradiated via the energy beam 4. The object 2 that has already been built in the manufacturing process depicted in the Fig., as well as the build material 3 that has not been consolidated or been freshly applied in the build plane 6 are carried by a carrying device 7, for example a build plate. The carrying device 7 is movable with respect to the build plane 6 in that while the object 2 is successively and layerwise built, the carrying device 7 can be successively lowered to allow for fresh layers of build material 3 to be applied in the build plane 6.

The irradiation device 5 is controlled via a control unit 8 that is adapted to automatically and repeatedly determine various process parameters of the additive manufacturing apparatus 1 dependent on basis of a machine-implemented determination routine, in particular the control unit 8 is adapted to determine process parameters relating the irradiation device 5. The process parameters may for example be key performance parameters, such as the energy of the energy beam 4, a spot size of the energy beam 4 on the build plane 6, a positioning accuracy of the energy beam 4, a focal position of the energy beam 4 and a positioning accuracy of the carrying device 7. Of course, the individual process parameters are only exemplary and any arbitrary process parameter that affect the additive manufacturing process performed by the apparatus 1 that is controlled by the control unit 8 can be used.

The control unit 8 further automatically stores the determined process parameters in a (data) storage unit 9. The process parameters that are determined via the control unit 8 can further be evaluated with respect to evaluation criteria. In the embodiment depicted in the sole Fig. a first evaluation criterion is the calibration status of the apparatus 1. To evaluate the calibration status of the apparatus 1 the determined process parameters are compared with reference process parameters that are defined and, for example, stored in the storage unit 9. If the comparison between the defined process parameter and the reference process parameter differs in that a predefined (threshold) value is exceeded, in particular if the difference is above a tolerance limit a calibration of the apparatus 1 is necessary and the process parameter is automatically stored, for example stored in the storage unit 9. Thus, a calibration at least regarding the corresponding process parameter can be performed. The calibration status may also subsequently be stored to the storage unit 9.

To calibrate the apparatus 1 the corresponding process parameter is adjusted in that the corresponding process parameter accepts a value within the tolerance limit. In particular, the process parameter may be set to the corresponding reference parameter.

Additionally, the determined process parameter can be evaluated with respect to a long-term behavior. Thus, it can be evaluated whether or how much the determined process parameter changes over time. Therefore, a period of time can be defined over which the process parameter shall be automatically and repeatedly determined and stored in the storage unit 9. The predefined period of time may be a week or a month or a year, wherein a change of the at least one process parameter and/or a change of the calibration status over the defined period can be evaluated. Particularly, a change information can be generated by comparing multiple determined process parameters that have been determined in the same period of time. It is also possible to generate a change information for the calibration status by comparing multiple determined calibration statuses of the same period of time. Thus, the behavior of both, the process parameter and the calibration status over time, can be evaluated, for example statistically evaluated. It is further possible to derive certain effects on the manufacturing process, for example of ambient parameters, that change during the period of time.

Further, multiple presets can be defined and stored, for example in the control unit 8 or in the storage unit 9 that comprise instructions on how the determination routine and/or the calibration routine has to be performed. In particular, it can be set via the preset when the determination routine and the calibration routine shall be performed. The preset can contain an initiation parameter that defines the date or the incident on which the determination routine and the calibration routine shall be initiated. Each preset may further comprise or set tolerance limits for the respective process parameters.

Dependent on the object 2 to be built, in particular which object 2 is currently built in the manufacturing apparatus 1, different presets can be selected via an operator and/or automatically via the control unit 8. Thus, different presets apply when manufacturing different objects 2.

## Claims

1. Method for operating an apparatus (1) for additively manufacturing of three-dimensional objects (2) by means of successive layerwise selective irradiation and consolidation of layers of a build material (3) which can be consolidated by means of an energy beam (4), **characterized in that** at least one process parameter of the apparatus (1), in particular a key performance parameter, is automatically repeatedly determined on basis of a machine-implemented determination routine, wherein the at least one determined process parameter is stored and automatically evaluated with respect to at least one evaluation criterion.

2. Method according to claim 1, **characterized in that** the at least one evaluation criterion relates to a long-term behaviour of the at least one process parameter and/or to a calibration status of the apparatus (1).

3. Method according to claim 1 or 2, **characterized in that** the automated and repeated determination is performed dependent on at least one initiation parameter, and/or at least one process parameter is adjusted dependent on the at least one determined process parameter.

4. Method according to claim 3, **characterized in that** the at least one initiation parameter comprises at least one of the following parameters:
- a time parameter, in particular relating to a time interval between two automated determinations of the at least one process parameter, preferably daily or weekly or monthly
- an incident parameter, in particular dependent on at least one process step, preferably at the beginning and/or the end of a manufacturing process and/or at a tool change
- a current and/or future work load of the apparatus (1)
- an operator input

5. Method according to one of the preceding claims, **characterized in that** the process parameter comprises at least one of the following parameters:
- an irradiation parameter, in particular a beam parameter, preferably a spot size and/or a scanning speed and/or a beam power and/or a wavelength and/or a focal length and/or a positioning accuracy
- a moving speed of at least one component of the apparatus (1), in particular a carrying device (7)
- a positioning accuracy, in particular of the carrying device (7)

6. Method according one of the preceding claims, **characterized in that** a calibration status of the apparatus (1) is evaluated dependent on the at least one determined process parameter and at least one reference parameter.

7. Method according one of the preceding claims, **characterized in that** the at least one process parameter and/or the at least one evaluated calibration status are stored in a storage unit (9).

8. Method according one of the preceding claims, **characterized in that** the calibration status is stored and evaluated over a defined period of time, in particular over a month and/or over a year, wherein a change of the at least one process parameter and/or the calibration status over the defined period is evaluated.

9. Method according to claim 8, **characterized in that** at least two calibration statuses evaluated in corresponding parts of the period of time, in particular evaluated in the same week or month of the period of time and/or at least two process parameters determined in corresponding parts of the period of time, in particular determined in the same week or month of the period of time are compared, wherein a change information is generated.

10. Method according one of the preceding claims, **characterized by** at least one preset defining the at least one process parameter to be determined and/or the at least one process parameter to be adjusted and/or the at least one initiation parameter.

11. Method according to claim 10, **characterized in that** the preset defines at least one tolerance limit for the at least one process parameter.

12. Method according to claim 8 or 9, **characterized in that** multiple presets are provided, wherein a preset can be selected dependent on the manufacturing process, in particular dependent on the object (2) to be man ufactu red.

13. Method according one of the preceding claims, **characterized by** the following steps:
- initiating the determination routine and/or the calibration routine based on the initiation parameter
- automatically setting the apparatus (1) in a determination mode
- determining at least one process parameter
- storing the at least one determined process parameter
- evaluating a calibration status
- adjusting at least one process parameter dependent on the calibration status

14. Apparatus (1) for additively manufacturing of three-dimensional objects (2) by means of successive layerwise selective irradiation and consolidation of layers of a build material (3) which can be consolidated by means of an energy beam (4), **characterized by** a control unit adapted to automatically determine at least one process parameter of the apparatus (1), in particular a key performance parameter, dependent on at least one initiation parameter, wherein the control unit is adapted to store the at least one determined process parameter in a data storage and/or the control unit is adapted to adjust at least one process parameter dependent on the at least one determined process parameter.

15. Apparatus according to claim 14, **characterized in that** the apparatus (1) is adapted to perform the method according to one of the claims 1 to 13.
